# EUROPÄISCHE PATENTANMELDUNG

(11) **EP 1 168 622 A2**
(43) Veröffentlichungstag der Anmeldung: **02.01.2002**
(21) Anmeldenummer: 01000216.0
(22) Anmeldetag: 15.06.2001
(51) Int. Cl.: H03K 17/97

(54) **Elektronisch gesteuerter Flüssigkeitsdrehknopf als haptisches Bedienelement**

(30) Priorität: 19.06.2000 DE 10029191
(71) Anmelder: Philips Corporate Intellectual Property GmbH, 52064 Aachen (DE); Koninklijke Philips Electronics N.V., 5621 BA Eindhoven (NL)
(72) Erfinder: Elferich, Reinhold, c/o Philips Corp.Int.Prop.GmbH, 52064, Aachen (DE); Lürkens, Peter, c/o Philips Corp.Int.Prop.GmbH, 52064, Aachen (DE)
(74) Vertreter: Volmer, Georg, Dipl.-Ing.

(57) **Zusammenfassung**

Die vorliegende Erfindung betrifft ein Bedienelement mit einem Drehknopf (4), mit einem Magnetkreis und mit mindestens einer Spule (1). Es ist dabei vorgesehen, dass der Drehknopf (4) bezüglich zumindest eines Teils des Magnetkreises drehbar gelagert ist, dass der zwischen Drehknopf (4) und Magnetkreis befindliche Spalt (5) mit einer magnetorheologischen Flüssigkeit gefüllt ist und dass die Spule (1) dazu vorgesehen ist, eine variable Bremswirkung am Drehknopf (4) hervorzurufen.

## Beschreibung

Die Erfindung betrifft ein Bedienelement mit einem Drehknopf, mit einem Magnetkreis und mit mindestens einer Spule.

Die Verwendung magnetischer Flüssigkeiten ist aus KR-A-9502031 bekannt. Es handelt sich dabei um einen Drehschalter, der aus einem Zylinder besteht, welcher auf einer drehbaren Welle befestigt und mit einem magnetischen Fluid gefüllt ist. Der Schalter trennt und verbindet einen elektrischen Kontakt mittels der auf einen Hebel übertragenen Drehbewegung des magnetischen Fluids.

Es ist Aufgabe der vorliegenden Erfindung, ein Bedienelement zu scharfen, welches dem Benutzer eine haptische Rückmeldung verschafft. Die haptische Rückmeldung soll dabei von einem festen Anschlag über spürbare Rastungen bis zu leichten Vibrationen reichen. Außerdem soll das Bedienelement möglichst wenig elektrische Energie verbrauchen.

Die Aufgabe wird erfindungsgemäß dadurch gelöst, dass der Drehknopf bezüglich zumindest eines Teils des Magnetkreises drehbar gelagert ist, dass der zwischen Drehknopf und Magnetkreis befindliche Spalt mit einer magnetorheologischen Flüssigkeit gefüllt ist und dass die Spule dazu vorgesehen ist, eine variable Bremswirkung am Drehknopf hervorzurufen. Der Magnetkreis, welcher die magnetorheologische Flüssigkeit umgibt, kann dabei einteilig ausgeführt sein oder mehrteilig. Dadurch lassen sich unterschiedliche Größen von Drehknöpfen einfach realisieren. Der Drehknopf kann mit unterschiedlicher Intensität und Länge gebremst werden, je nachdem ob ein Anschlag simuliert wird oder ein Rastgefühl zu spüren sein soll. Der Aufbau erweist sich dabei als sehr robust besonders im Vergleich zu einem herkömmlichen Drehknopf, dessen Antrieb ein Elektromotor mittels eines Getriebes übernimmt. Außerdem sind die Kräfte, die ein Elektromotor ausüben kann, trotz Getriebe um ein Vielfaches geringer, wodurch der simulierte Anschlagspunkt vom Benutzer leicht überdreht werden kann. Des weiteren verbraucht ein Elektromotor deutlich mehr Strom, was den Einsatz bei portablen Geräten wie Mobiltelefonen unmöglich macht.
Die Ausgestaltung nach Anspruch 2 zeichnet sich dadurch aus, dass sie mit dünnwandigen weichmagnetischen Teilen auskommt, was das Bauvolumen und das Gewicht verkleinert.
Trotzdem ist das radial verlaufende Magnetfeld stark genug, die magnetorheologische Flüssigkeit so in ihrer Viskiosität zu verändern, dass dem Benutzer das Gefühl eines nicht zu überdrehenden Anschlag vermittelbar ist.

Mit der Ausführungsform nach Anspruch 3 wird verhindert, dass die magnetorheologische Flüssigkeit den Spalt verlässt. Dazu ist es notwendig, die in der Flüssigkeit vorhandenen festen Bestandteile wie Metallspäne mittels magnetischer Kräfte vom unmittelbaren Lagerbereich fernzuhalten, das sie sonst das Lager verstopfen und Bremswirkungen hervorrufen, was nach kurzer Betriebsdauer zu einer Zerstörung des Lagers führt. Mit einem Dichtungselement wird zugleich verhindert, dass die Trägersubstanz der Flüssigkeit, die zumeist aus Wasser oder Öl besteht, aus dem Spalt austritt.

Durch die Ausgestaltung nach Anspruch 4 ist es möglich, die Lagerung des Drehknopfs ohne zusätzliche mechanische Lager vorzunehmen. Hierbei umschließt der Drehknopf den nicht beweglichen Stator der Art, dass ein Abziehen des Drehknopfs von dem Stator nicht möglich ist. Damit schwimmt der Drehknopf auf der magnetorheologischen Flüssigkeit im Spalt zwischen Drehknopf und dem Stator, was eine verschleißfreie Lagerung ermöglicht.

Durch die Ausgestaltung nach Anspruch 5 kann der Drehknopf an jedem Elektrogerät angebracht werden, da er nicht in das Gehäuse hineinragt und so im Innern des Geräts keinen zusätzlichen Platz benötigt.

Die Ausgestaltungen nach den Ansprüchen 6 und 7 erlauben eine genaue Positionsermittelung des Drehknopfs. Mit den eingesetzten Hallsensoren, welche von einem Magnetfeld durchflutet werden, kann der volle Drehbereich von 360 ° hinreichend genau aufgelöst werden, wobei der Sensor auch die Anzahl der Umdrehungen erfassen kann, wenn der Drehwinkel mehr als 360 ° beträgt. Außerdem arbeiten die Sensoren berührungslos und damit verschleißfrei und lassen sich gut in den Drehknopf integrieren. Weist der Drehknopf eine Tastfunktion in axialer Richtung auf, so kann mit den selben Hallsensoren auch der Zustand "gedrückt" oder "nicht gedrückt" ermittelt werden, da die Hallsensoren je nach Tasterstellung unterschiedlich stark vom Magnetfeld durchflutet werden.
In den Ansprüchen 8 bis 11 werden vorteilhafte Ausgestaltungen beschrieben, welche sich auf die elektronische Ansteuerung des Drehknopfs beziehen. Durch eine solche elektronische Ansteuerung ist es möglich, die unterschiedlichsten Rückmeldungen durch den Drehknopf zu programmieren. Je nach dem, wo das Bedienelement eingesetzt wird, kann es unterschiedliche Funktionen wahrnehmen und unterschiedliche Rückmeldungen erzeugen. So ist es möglich, für einen bestimmten Drehwinkel das Gefühl eines Anschlags zu vermitteln, so dass dieser Drehwinkel nicht überschritten wird. Dazu wird ein Drehwinkel programmiert, ab dem die Spule des Drehknopfs unter Strom gesetzt wird, wodurch eine starke Bremswirkung auftritt. Dazu wird der über die Hallsensoren ermittelte aktuelle Drehwinkel mit dem einprogrammierten Drehwinkel des Anschlagspunkts verglichen und beim Erreichen dieses Punkts der Strom für die Spule eingeschaltet. Da der Benutzer den Drehknopf oft mit Schwung und überhöhter Kraft etwas über den Anschlagspunkt hinausdrehen kann, ist eine Funktion vorgesehen, die sicherstellt, dass die Bremswirkung des Drehknopfs sofort aufgehoben wird, wenn dieser in die Gegenrichtung gedreht wird. Ohne diese Funktion entstünde beim Benutzer kurzzeitig das Gefühl, dass der Drehknopf festklebt, da die Bremswirkung erst wieder beim Erreichen des Anschlagspunkts aufgehoben würde. Es ist auch möglich dem Benutzer das Gefühl eines Einrastens des Drehknopfs zu vermitteln, in dem der Drehknopf kurz abgebremst wird. Je nach Bremsfrequenz kann dieses Gefühl des Einrastens in Vibrationen übergehen.

Die Ausgestaltungen nach den Ansprüchen 12 und 13 betreffen besonders vorteilhafte Einsatzgebiete des erfindungsgemäßen Drehknopfs. So eignet sich der Drehknopf hervorragend dazu, graphische Benutzeroberflächen zu steuern. Bei jedem Menüpunkt spürt der Benutzer ein kurzes Klicken, welches je nach Wichtigkeit des einzelnen Menüpunkts unterschiedlich stark ausfallen kann. Dies ist besonders in Fahrzeugen von Vorteil, da hier der Fahrzeugführer die Benutzeroberfläche während der Fahrt blind steuern kann, indem er sich ausschließlich auf die haptische Rückmeldung des Drehknopfs verlässt. Dadurch muss er den Blick nicht von der Straße abwenden, was die Verkehrssicherheit erhöht. Gleichzeitig lässt sich so die Anzahl der Knöpfe und Schalter eines Cockpits stark reduzieren, da der Drehknopf beliebig viele Funktionen wahrnehmen kann. Außerdem eignet sich das Bedienelement auch für den Einsatz in tragbaren Geräten wie Mobiltelefonen, da es sehr wenig Strom verbraucht.
Mit der Ausgestaltung nach Anspruch 14 lässt sich die Benutzerfreundlichkeit weiter erhöhen. So kann eine synthetische Stimme das Erreichen eines mit dem Drehknopf ausgewählten Menüpunkts der graphischen Benutzeroberfläche mit Worten kommentieren, wodurch der Fahrer eine eindeutige und zweifelsfreie Bestätigung der ausgewählten Menüpunkte erhält.

Mehrere Ausführungsbeispiele der Erfindung werden nachfolgend an Hand von Figuren näher erläutert. Es zeigen:
Figur 1 einen Drehsteller in Spaltrohrausführung für den Einbau in eine Gehäusewand,
Figur 2 zeigt einen weiteren Drehsteller,
Figur 3 zeigt eine dritte Ausführungsform eines Drehstellers,
Figur 4 das Schaubild eines Algorithmus zur Simulation eines haptischen Anschlags,
Figur 5 die zeitlichen Verläufe der Signale, welche der Algorithmus verarbeitet und
Figur 6 den zeitlichen Verlauf des Positionssignals im Rastbetrieb.

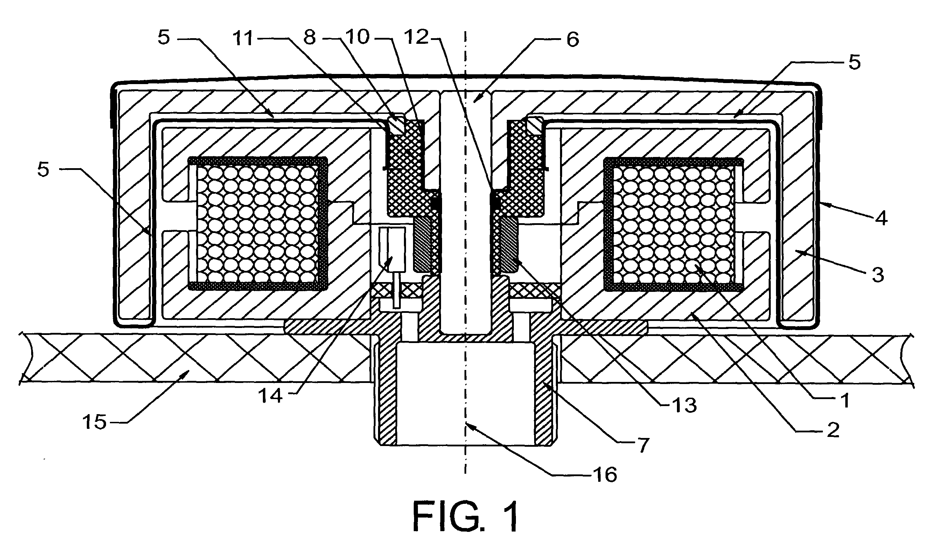

Der in Figur 1 gezeigte Drehsteller in Spaltrohrausführung ist für den Einbau in eine Gehäusewand 15 vorgesehen. Der Drehsteller ist im wesentlichen bezüglich einer Achse 16 achsensymmetrisch aufgebaut und besitzt eine Ringspule 1, welche in einem weichmagnetischen Jochring 2 untergebracht ist, der im Bereich zwischen seinen inneren Polschuhen und einem äußeren weichmagnetischen Ring 3 ein radial verlaufendes Magnetfeld erzeugt. Der Jochring 2 stellt somit zusammen mit dem weichmagnetischen Ring 3 einen Magnetkreis da Der Ring 3 ist über eine Achse 6 und eine Grundplatte 7 mit dem Jochring 2 fest verbunden und nicht drehbar. Dagegen ist ein dünnwandiges Stellrad 4, welches den Ring 3 umschließt, drehbar ausgeführt. Das Stellrad 4 kann z.B. als zweiteiliges Tiefziehteil in Form einer Dose oder eines Deckels hergestellt werden. Die zwischen dem Ring 3 und dem Stellrad 4 vorhandenen Spalte 5 sind dabei mit einer magnetorheologischen Flüssigkeit gefüllt. Unter einer magnetorheologischen Flüssigkeit wird eine Flüssigkeit verstanden, die ihre Viskosität unter Einwirkung eines Magnetfeldes verändert. Wird nun die Spule 1 unter Strom gesetzt, erhöht sich die Schubspannung zwischen dem Stellrad 4 und dem feststehenden Ring 3, durch eine Bremswirkung erzielt wird.

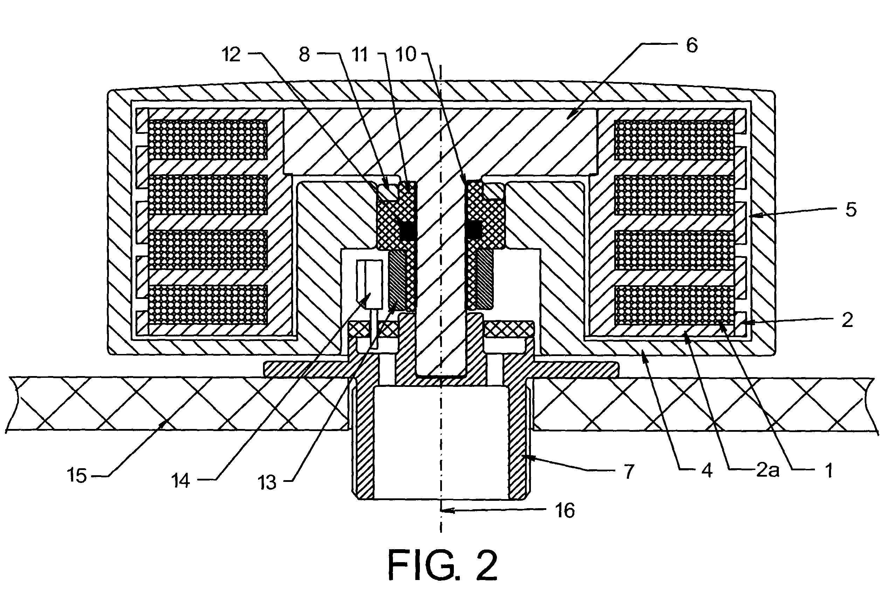

Auch die Ausführung nach Figur 2 ist im wesentlichen symmetrisch zu einer Achse 16 aufgebaut. Allerdings ist hier das Stellrad 4, welches als Rückschlusseisenring dient, ein drehbarer Bestandteil des Magnetkreises. Das Stellrad 4 umschließt die feststehende Anordnung aus Jocheisen 2a, Spulen 1 und mehreren Jochringen 2. Auch hier wird ein radial verlaufendes Magnetfeld erzeugt, welches sich im Spalt 5 zwischen den Jochringen 2 und dem Stellrad 4 befindet. In diesem Spalt 5 ist eine magnetorheologische Flüssigkeit vorhanden. Im Unterschied zu der Anordnung nach Figur 1 ist hier der Magnetkreis längs der Achse 16 mehrpolig ausgeführt, wobei der Wickelsinn von Spule zu Spule wechselt. Durch die mehrpolige Anordnung können die weichmagnetischen Teile dünnwandiger ausgeführt werden.

Im Spalt 10 befindet sich eine zweiteilige Wellendichtung Ein Ring 8 aus hartmagnetischem Material sorgt dafür, dass die in der magnetorheologischen Flüssigkeit vorhandenen feinen Metallspäne nicht in den inneren Dichtungs- und Lagerbereich gelangen. Da bei derartigen Fluiden wegen der Größe ihrer Metallpartikel eine Entmischung von der Trägersubstanz (Öl, Wasser) grundsätzlich vorkommen kann, wird ein weiteres Dichtungselement 12 zum Zurückhalten der Trägersubstanz eingesetzt. Der Magnetdichtring 8 und der vorzugsweise aus Kunststoff bestehende Dichtring 12 werden von einem Dichtungsträger 11 gehalten, welcher ferner den beweglichen Teil einer Drehwinkelsensorik trägt. Die Sensorik führt eine magnetische Positionserfassung mit zwei Hallsensoren 14 und einem Sensormagnetrad 13 durch. Um eine kontinuierliche Auflösung bei einem Drehwinkel von bis zu 360 ° zu erreichen, ist das Sensormagnetrad 13 quer zu seiner Drehachse magnetisiert. Als Material des Sensormagnetrads 13 reicht preiswertes hartmagnetisches Plastoferrit. Die Jochringe 2 bilden den Magnetkreisrückschluss der Sensoren 14. Die Hallsensoren 14 sind fest mit der Grundplatte 7 verbunden und sind jeweils magnetisch und hier auch geometrisch um 90 ° gegenüber der Achse 16 versetzt angeordnet. Die Auswertung der Phasenlagen der Sensorsignale ergibt die Position.
In einer weiteren Ausführung kann auch der Rotor 1a selbst magnetisch sein und somit den magnetischen Rückschluss darstellen. In diesem Fall kann auf den Rückschluss 2a verzichtet werden; ferner entsteht nur auf der Außenseite des Rotors 1a die gewünschte Scherwirkung. Allerdings ist der magnetisch zu durchflutende Spalt 5 hierbei kürzer. Der Rotor 1a (in den oben beschrieben Ausprägungen) kann auch als Außenläufer gestaltet sein. D.h., der Flüssigkeitsspalt 5 befindet sich radial außerhalb des die Ankerwicklung 7 tragenden Statorteils 2.

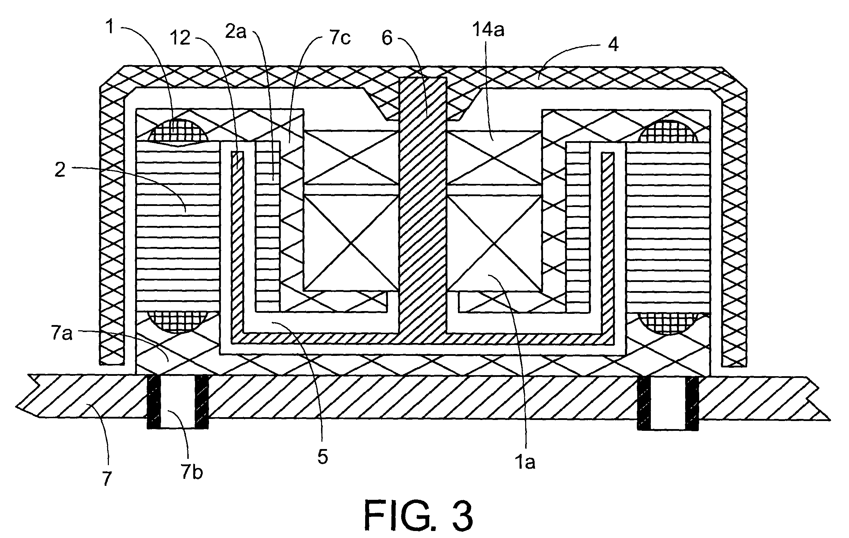

In einer erweiterten Ausführung sind das Stellrad 4 sowie das Ensemble 3, 8, 11, 13 bezüglich der Grundplatte 7 axial um wenige Millimeter beweglich, durch eine Tastfunktion realisierbar ist. Die Verbindung zwischen der Achse 6 und der Grundplatte 7 weist dabei eine Verdrehsicherung auf. Die Tastfunktion kann nun mit derselben Sensoranordnung detektiert werden. Hierzu wird das Magnetrad 13 axial derart angeordnet, dass es in der Grundposition axial nur teilweise die Hallsensoren 14 durchflutet, während es in der Endstellung vollständig in den Sensorbereich eintaucht und die Sensoren 14 damit stärker durchflutet. Beide überlagerten Bewegungen lassen sich unabhängig voneinander auswerten, indem der Drehwinkel über die Phasenlage der Sensorsignale detektiert wird Dies ist z.B. in dem IC UZZ9000 von Philips mit Hilfe des Cordic Algorithmus realisiert. Dieser bewertet die beiden Sensorsignale als einen Punkt auf einer kreisförmigen Ortskurve, dessen Phasenlage er berechnet. In weiten Bereichen ist dies von den Amplituden der Sensorsignale unabhängig. Dadurch kann ohne zusätzlichen Sensor eine Bewegung in Axialrichtung detektiert werden. Bei der beschriebenen Anordnung von Sensoren 14 und Magnetrad 13 führt eine solche Bewegung zu einer gezielten Vergrößerung des Radius der Sensorsignalortskurve, welche leicht ermittelt werden kann. Figur 3 zeigt einen Drehsteller mit einem geblechten Statorteil 2, welches aus weichmagnetischem Material besteht, eine Ankerwicklung 1 trägt und ein radial verlaufendes Magnetfeld in einem magnetisch wirksamen Spalt 5 zwischen Statorteil 2 und 2a erzeugt. Auch das Statorteil 2a besteht aus einem weichmagnetischen Material. Im Spalt 5 befindet sich ein ringförmiger, nichtmagnetischer Rotor 1a, der über eine Welle 6 mit einem glockenförmigen Bedienkörper 4 verbunden ist. Ferner befindet sich im Spalt 5 eine magnetisch wirksame Flüssigkeit. Die Statorteile 2, 2a sind mittels geeigneter Halteflansche 7a mit der Gehäuse- /Montagewand 7 verbunden. Die elektrischen Verbindungen zwischen Drehsteller und Antriebselektronik, werden durch Hülsen 7b geführt. Der Rotor 1a wird bezüglich des Stators 2 mittels geeigneter Vorrichtungen gelagert. Ferner befindet sich im Bereich der Wellendurchführung der Welle 6 durch die Flüssigkeitsbehälterwand eine geeignete Dichtung 12. Die Positionserfassungssensorik kann im Bereich 14a ausgeführt werden. Diese Bauweise ermöglicht auch den Verzicht auf herkömmliche Lager, da hier der Drehknopf 4 und die an ihm befestigte T-förmige Achse 6 in der magnetorheologischen Flüssigkeit gelagert werden. Auf Grund der Form der Achse 6 kann diese den Spalt 5 nicht verlassen.

In einer erweiterten Ausführung wird die Spule 1 während des Klemmvorgangs nicht kontinuierlich unter Strom gesetzt, sondern durch einen Pulsgenerator PG mittels Pulsweiten-Modulation (PWM) getaktet. Das PWM-Muster wird charakterisiert durch seine Frequenz f und seinen Tastgrad d. Die Frequenz f liegt dabei oberhalb des haptisch relevanten Bereichs (>1 kHz). Ein solcher Bereich erleichtert auch die Detektion des Drehsinns, da ein in den Drehsteller geleitetes Drehmoment zu stärker ausgeprägten Mikroschrittbewegungen führt, wodurch aufgrund des Hochpassfilters HF die Empfindlichkeit der gesamten Anordnung steigt.

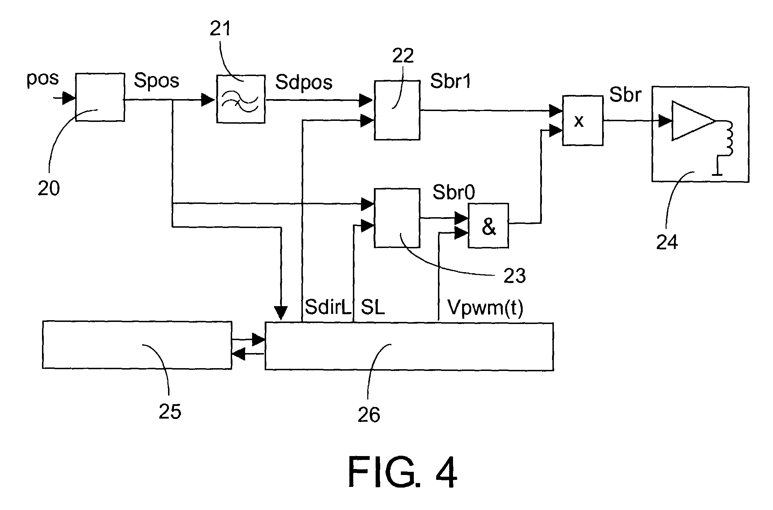

Nachfolgend wird ein in Figur 4 dargestellter Algorithmus zur haptischen Darstellung eines programmierbaren Anschlags beschrieben. Dieser ist in Form einer diskreten Schaltung oder eines Programms, welches auf einem Signalprozessor abläuft, zu verwirklichen. Die Drehwinkelposition des Rotors pos wird mittels eines Drehwinkelsensors 20 in ein drehwinkelrepräsentierendes Signal Spos umgesetzt. Dieses Signal wird mit einem von einer Betriebssteuerung 26 vorgegebenen Referenzsignal SL mittels eines Komparators 23 verglichen. Befindet sich die Rotorposition im durch SL gegebenen Anschlagbereich, erzeugt dies das Freigabesignal Sbr0. Die Höhe der Bremskraft kann beispielsweise über das Tastverhältnis eines Signals Vpwm(t) moduliert werden. Das Bremssignal Sbr setzt über einen Leistungsverstärker 24 die Ankerwicklung 1 unter Strom.

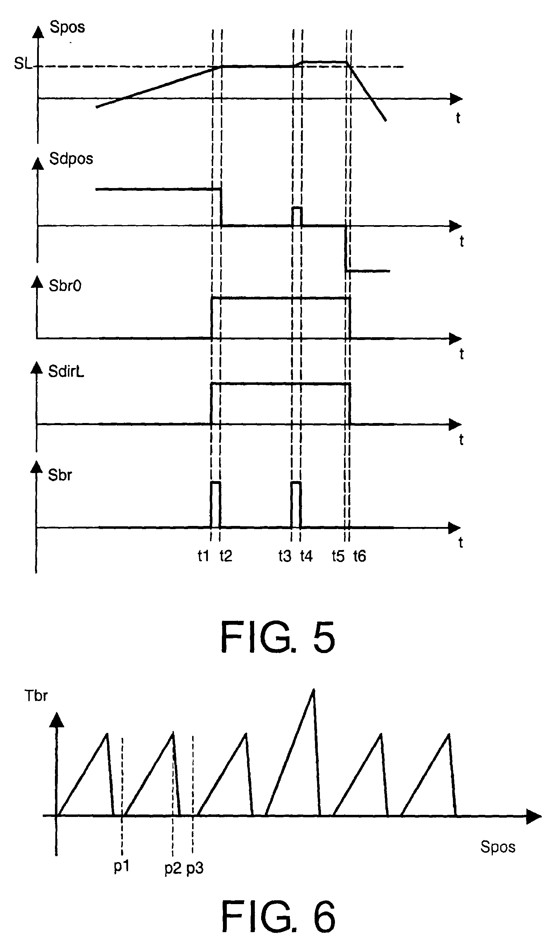

Würde der Bremsvorgang ausschließlich auf diese Weise gesteuert, ergäbe sich der Nachteil, dass ein fortwährendes Bremsmoment aufgebracht würde, welches sich beim Herausdrehen des Drehknopfs aus der durch SL bestimmten Anschlagposition den Eindruck eines Festhaftens hervorrufen würde. Daher wird aus dem Positionssignal Spos mittels eines Hochpassfilters 21 ein Signal Sdpos erzeugt, welches der Änderung der Bewegung bezüglich der Zeit entspricht. Dieses wird mit einem über die Bewegungssteuerung 26 vorgegeben Signal SdirL verglichen. Stimmen beide Signale (Sdpos und SdirL) dem Vorzeichen nach überein und ist der Bremsvorgang ferner über Sbr0 freigegeben, wird die Ankerwicklung 1 unter Strom gesetzt und damit der Bremsvorgang eingeleitet. Über eine Verbindung zu einer übergeordneten Anwendungssteuerung 25, welche die Betriebsart wählt (Rastbetrieb, Bremsbetrieb) und die eingestellten Positionen auswertet, erfolgt die Einbindung in die Gerätesteuerung.
Die Signalverläufe in Figur 5 zeigen schematisch und beispielhaft einen Bremsvorgang: Zum Zeitpunkt t1 erreicht das Positionssignal Spos den Anschlagbereich SL. Die Bremsung erfolgt, da gleichzeitig die Drehrichtung Sdpos der Vorgabe (hier positiv) entspricht. Der Rotor dreht sich um einen kleinen Winkel über den Vorgabewrt SL hinaus. Der genaue Betrag hängt von der Drehbeschleunigung zum Zeitpunkt t1 und dem eingestellten Bremsstrom ab. Zum Zeitpunkt t2 ist der Rotor zum Stillstand gekommen. Der Bremsstrom geht zurück. Im Zeitpunkt t3 findet eine weitere Bewegung gegen den Anschlag statt, die unmittelbar eine erneute Versorgung der Ankerwicklung mit Strom bewirkt. Zum Zeitpunkt t4 steht der Rotor. Eine Bewegung aus dem Anschlag heraus führt im Zeitpunkt t5 nicht zu einer Stromzufuhr zur Ankerwicklung, da die Vorzeichenbedingung für Sdpos nicht erfüllt ist. Im Zeitpunkt t6 verlässt der Rotor wieder den Anschlagbereich.

In Figur 6 ist der Signalverlauf von Spos für den Fall dargestellt, dass sich der Drehknopf 4 im Betriebsmodus Rasten befindet. Hierzu wird eine im wesentlichen positionsabhängige Bremswirkung erzeugt. Diese Bremsfunktion ist in der Steuerungselektronik abgespeichert. In Abhängigkeit des gemessenen Positionssignals Spos werden die Ankerspulen 1 der Art mit Strom versorgt, dass die gewünschte Bremswirkung des Drehknopfs 4 eintritt. Dreht der Benutzer am Knopf 4, so bewirkt das beim Benutzer ein Gefühl abwechselnd positiver und negativer Beschleunig, was dem haptischen Eindruck eines Rastens entspricht. Eine negative Beschleunigung tritt in Figur 6 im Bereich zwischen p1 und p2 auf, eine positive Beschleunigung im Bereich zwischen p2 und p3, wobei TBr das eingestellte Drehmoment bezeichnet und Spos wie oben die Drehwinkelposition angibt. Die Ausführung der Bremsfunktion kann zusätzlich auch noch abhängig von der gemessenen Drehgeschwindigkeit des Knopfs 4 und seiner Drehrichtung programmiert werden.

Das erfindungsgemäße Bedienelement eignet sich hervorragend zur Steuerung von Funktionen im Cockpit von Autos oder anderen Transportmitteln. So kann er in Verbindung mit einem Navigationssystem eingesetzt werden, um dessen Funktionen zu steuern. Da diese Systeme meist mit einer synthetischen Sprachführung versehen sind, kann diese dazu verwendet werden, das Erreichen eines Menüpunkts der graphischen Benutzeroberfläche mit Worten zu kommentieren, um so dem Benutzer zusätzliche Sicherheit bezüglich des angewählten Menüpunkts zu geben.

## Patentansprüche

1. Bedienelement mit einem Drehknopf (4), mit einem Magnetkreis und mit mindestens einer Spule (1),
**dadurch gekennzeichnet,**
**dass** der Drehknopf (4) bezüglich zumindest eines Teils des Magnetkreises drehbar gelagert ist, dass der zwischen Drehknopf (4) und Magnetkreis befindliche Spalt (5) mit einer magnetorheologischen Flüssigkeit gefüllt ist und dass die Spule (1) dazu vorgesehen ist, eine variable Bremswirkung am Drehknopf (4) hervorzurufen.

2. Bedienelement nach Anspruch 1,
**dadurch gekennzeichnet,**
**dass** das Magnetfeld in der magnetorheologischen Flüssigkeit in radialer Richtung verläuft.

3. Bedienelement nach Anspruch 1,
**dadurch gekennzeichnet,**
**dass** ein Ring (8) aus hartmagnetischem Material dazu vorgesehen ist, die in der magnetorheologischen Flüssigkeit enthaltenen Metallspäne vom Lager- und Dichtungsbereich (10) fernzuhalten und dass ein weiteres Dichtungselement (12) dazu vorgesehen ist, die Trägersubstanz der magnetorheologischen Flüssigkeit im Spalt (5) sicher einzuschließen.

4. Bedienelement nach Anspruch 1,
**dadurch gekennzeichnet,**
**dass** der Ring (8) aus hartmagnetischem Material dazu vorgesehen ist, in Verbindung mit dem Dichtungselement (12) und der magnetorheologischen Flüssigkeit im Spalt (5) die Funktion eines Lagers zu übernehmen.

5. Bedienelement nach Anspruch 1,
**dadurch gekennzeichnet,**
**dass** die gesamte mechanische Anordnung und die benötigten Sensoren (14) im Innern des Drehknopfs (4) vorgesehen sind.

6. Bedienelement nach Anspruch 1,
**dadurch gekennzeichnet,**
**dass** in dem Bedienelement Hallsensoren (14) und ein Sensormagnetrad (13) dazu vorgesehen sind, die Position des Drehknopfs (4) gegenüber dem feststehenden Teil des Magnetkreises zu bestimmen.

7. Bedienelement nach Anspruch 1,
**dadurch gekennzeichnet,**
**dass** der Drehknopf (4) geeignet ist, eine Tastfunktion in axialer Richtung seiner Drehachse (6) auszuführen und dass die Hallsensoren (14) und das Sensormagnetrad (13) so in das Bedienelement eingebaut sind, dass sie neben der Drehposition auch die Tastfunktion des Drehknopfs (4) erfassen können.

8. Bedienelement nach Anspruch 1,
**dadurch gekennzeichnet,**
**dass** eine elektronische Schaltung zur Ansteuerung der Spule (1) vorgesehen ist, welche die Spule (1) mit Strom versorgt.

9. Bedienelement nach Anspruch 8,
**dadurch gekennzeichnet,**
**dass** die elektronischen Schaltung dazu vorgesehen ist, abhängig vom Drehwinkel des Drehknopfs (4) das Gefühl eines mechanischen Anschlags zu simulieren

10. Bedienelement nach Anspruch 8,
**dadurch gekennzeichnet**
**dass** die elektronischen Schaltung dazu vorgesehen ist, in Abhängigkeit des Drehwinkels des Drehknopfs (4) und der Zeit Rastfunktionen und andere Bremsfunktionen zu steuern.

11. Bedienelement nach Anspruch 9,
**dadurch gekennzeichnet,**
**dass** die elektronische Schaltung den Drehknopf (4) so steuert, dass die Bremswirkung des Drehknopfs (4) auch nach einem gewaltsamen Überdrehen weit über den simulierten Anschlag hinaus bei einer Drehung in die entgegengesetzte Richtung sofort aufgehoben wird.

12. Bedienelement nach Anspruch 8,
**dadurch gekennzeichnet,**
**dass** das Bedienelement dazu vorgesehen ist, eine graphische Benutzeroberfläche zu steuern.

13. Bedienelement nach Anspruch 8,
**dadurch gekennzeichnet,**
**dass** das Bedienelement dazu vorgesehen ist, die Funktionen herkömmlicher Tasten an elektrischen Geräten zu übernehmen.

14. Bedienelement nach Anspruch 10,
**dadurch gekennzeichnet,**
**dass** das Bedienelement bei Erreichen eines Menüpunkts auf der graphischen Benutzeroberfläche eine zusätzliche Rückmeldung in Form synthetischer Sprache vermittelt.
